(19)

Europäisches
Patentamt
European
Patent Office
Office européen
des brevets

(11) **EP 2 267 805 A1**

(12) **EUROPEAN PATENT APPLICATION**

(43) Date of publication:
**29.12.2010 Bulletin 2010/52**

(51) Int Cl.:
***H01L 37/04*** *(2006.01)*

(21) Application number: **09161615.1**

(22) Date of filing: **01.06.2009**

(84) Designated Contracting States:
**AT BE BG CH CY CZ DE DK EE ES FI FR GB GR HR HU IE IS IT LI LT LU LV MC MK MT NL NO PL PT RO SE SI SK TR**

(71) Applicant: **ABB Research Ltd.**
**8050 Zürich (CH)**

(72) Inventors:
• **Russberg, Gunnar**
**724 62, Västerås (SE)**

• **Thorburn, Stefan**
**723 48, Västerås (SE)**

(74) Representative: **Kock, Ina**
**ABB AB**
**Intellectual Property**
**Ingenjör Bååths Gata 11**
**721 83 Västerås (SE)**

(54) **Arrangement and method for thermomagnetic power generation**

(57)    The present invention relates to an arrangement for converting thermal energy into electric energy comprising at least two thermomagnetic elements comprising a material exhibiting a magnetic phase transition, wherein the phase transition of the elements is at different temperatures. The at least two elements are arranged in at least one cascaded series in a manner so that an element having a first transition temperature is arranged to receive cooling fluid from a cooling fluid outlet arranged to deliver cooling fluid from an element having a lower phase transition temperature than the first transition temperature. The invention further relates to a thermomagnetic generator and a method of operating a thermomagnetic generator.

## Fig. 4

**EP 2 267 805 A1**

## Description

### *Technical field*

The present invention relates to the field of electric power generation, and in particular to the field of transforming thermal energy into electrical energy by means of materials displaying a magnetic phase transition.

### *Background*

The concept of transforming thermal energy into electrical energy by means of materials displaying a magnetic phase transition has been known for a long period of time. Early patents in the field date back to the great inventors of the 19th century, such as for example UK patent 16709 to Thomas Edison, and US patent 428,057 to Nikola Tesla. The transformation of thermal energy into electrical energy by means of a material displaying a magnetic phase transition is also disclosed in US patent 655,087.

The transformation of thermal energy into electrical energy by means of materials displaying a magnetic phase transition, hereinafter referred to as thermomagnetic materials, has generally been considered to be too inefficient and cumbersome to be exploited in commercial power production. However, with the ever-increasing demand for power around the globe, and in view of the environmental issues involved in several power-production techniques, the prospects of the clean power production methods provided by the thermomagnetic materials seem very attractive.

Lately, improvements have been made to generator devices utilizing the possibility of extracting electrical energy from materials displaying magnetic phase transitions. Generator arrangements for converting thermal energy into electrical energy by means of thermomagnetic materials have been disclosed in patent applications WO2008/116785, WO2008/116789 and WO2008/116792. Although the generator arrangements disclosed in the above mentioned patent publications provide interesting methods of power generation, there is a desire to further improve the generator arrangements that utilize thermomagnetic materials.

### *Summary*

A problem to which the present invention relates is how to improve the efficiency of power generation by means of thermomagnetic materials.

One embodiment provides an arrangement for converting thermal energy into electric energy, the arrangement comprising at least two thermomagnetic elements, wherein an element comprises a material exhibiting a magnetic phase transition and wherein the phase transition of the elements are at different temperatures. The arrangement further comprises inlet valve devices and outlet valve devices, and an element is connected between an inlet valve device and an outlet valve device. The at least two elements are arranged in at least one cascaded series in a manner so that a cooling fluid inlet of the inlet valve device of an element having a phase transition temperature higher than the lowest phase transition temperature of the cascaded series is arranged to receive cooling fluid from a cooling fluid outlet of an outlet valve device of an element having a lower phase transition temperature; and a heating fluid inlet of the inlet valve device of an element having a phase transition temperature lower than the highest phase transition temperature of the cascaded series is arranged to receive heating fluid from a heating fluid outlet of an outlet valve device of an element having a higher phase transition temperature.

By this arrangement is achieved that the heating power of any supplied heating fluid can efficiently be utilized. Furthermore, the cooling power of any supplied cooling fluid can also be efficiently utilized. Hence, the energy conversion efficiency can be improved.

An electric generator may advantageously include an arrangement for converting thermal energy into electric energy.

In one embodiment, the at least one cascaded series is a single cascaded series of thermomagnetic elements. A cooling fluid outlet of an outlet valve device of an element having the highest transition temperature of the cascaded series is connected to an inlet of a heat source arranged to heat fluid received at said inlet, and wherein an outlet of the heat source is connected to a heating fluid inlet of an inlet valve device of the element having the highest transition temperature.

In another embodiment, the at least one cascaded series is at least two cascades series. A cooling fluid outlet arranged to deliver cooling fluid from the element having the highest transition temperature of a first cascaded series is connected to a heating fluid inlet serving the element having the highest transition temperature of a second cascaded series. The element in the second cascade which has the highest transition temperature of the second cascade could advantageously have a lower transition temperature than the transition temperature of the element of the first cascade which has the highest transition temperature of the first cascade.

An inlet valve device may have a heating fluid inlet for receiving a flow of heating fluid, a cooling fluid inlet for receiving a flow of cooling fluid, and an outlet for delivering, to an element, a unidirectional fluid flow comprising heating and cooling fluid pulses. An outlet valve device may have an inlet for receiving, from an element, a fluid flow comprising heating and cooling fluid pulses; the outlet valve device being arranged to separate received heating and cooling fluid pulses into a flow of cooling fluid and a flow of heating fluid; the outlet valve device further having a heating fluid outlet for delivering a flow of heating fluid, and a cooling fluid outlet for delivering a flow of cooling fluid. The possibility of generating a unidirectional flow of heating and cooling fluid pulses from an inlet valve device ensures that a continuous flow of fluid may be applied to the elements, thus reducing the mechanical stress in the elements and the energy required for generation of the flow of fluid.

An inlet valve device may comprise a rotatable member for generation of a unidirectional fluid flow of heating and cooling fluid pulses, the rotatable member being arranged to separate a heating fluid inlet of the valve device from a cooling fluid inlet of the valve device, and to alternately separate an outlet of the valve device from the heating fluid inlet and the cooling fluid inlet. By use of such rotatable member, a continuous flow of heating and cooling fluid through an inlet valve device may be ensured, thus reducing the mechanical stress on the inlet valve device and pipes connected thereto, and reducing the energy required for generation of the fluid flow. The rotatable members of different inlet valve devices may for example be arranged on the same rotating shaft.

One embodiment provides a method of operating a thermomagnetic generator having at least two thermomagnetic elements comprising a material exhibiting a magnetic phase transition wherein the elements have different phase transition temperatures. The method comprises: supplying a first thermomagnetic element of a first phase transition temperature with a unidirectional flow of alternately heating and cooling pulses, the flow of alternately heating and cooling pulses providing temperature cycling of the first element; separating the unidirectional flow of alternately heating and cooling pulses having provided temperature cycling of the first element into a heating fluid flow and a cooling fluid flow; supplying a second thermomagnetic element of a second phase transition temperature with the cooling fluid flow, the second phase transition temperature being higher than the first phase transition temperature; and/or supplying a third thermomagnetic element of a third phase transition temperature with the heating fluid flow, the third phase transition temperature being lower than the first phase transition temperature.

Further aspects of the invention are set out in the following detailed description and in the accompanying claims.

### Brief description of the drawings

| | |
|---|---|
| Fig. 1 | is a schematic illustration of a thermomagnetic element the temperature of which may be varied by means of a fluid transportation system. |
| Fig. 2a | is a schematic cross cut of an example of a rotating valve which can be used in a fluid transportation system. |
| Fig. 2b | is a schematic perspective illustration of the rotating valve shown in Fig. 2a. |
| Fig. 2c | is a schematic illustration of an example of a rotating valve having one outlet comprising twelve sub-outlets. |
| Fig. 3 | is a schematic illustration of an example of a multi-cascade system of thermomagnetic elements. |
| Fig. 4 | is a schematic illustration of an example of a single-cascade system of thermomagnetic elements. |
| Fig. 5 | is a schematic illustration of a further example of a single-cascade system of thermomagnetic elements. |
| Fig. 6 | is a schematic illustration of an example of a cascade. |
| Fig. 8a | schematically illustrates an example of a synchronization mechanism for optimization of the separation of heating and cooling fluid pulses in an outlet valve device. |
| Fig. 8b | schematically illustrates a further example of a synchronization mechanism for optimization of the separation of heating and cooling fluid pulses in an outlet valve device. |
| Fig. 9 | schematically illustrates an example of a synchronization mechanism for synchronizing at least two inlet valve devices in a system of thermomagnetic elements. |

### Detailed description

A generator may be designed by means of a thermomagnetic material, the term thermomagnetic material here being used to refer to materials displaying a magnetic phase transition including ferromagnetic, ferrimagnetic and anti-ferromagnetic phase transitions.

The macroscopic magnetization of a ferro- or ferri-magnetic material in an external magnetic field will increase drastically as the temperature of the ferro/ferri-magnetic material is lowered below the phase transition temperature $T_{PT}$ (Curie or Néel temperature, respectively). Variations in the macroscopic magnetization give rise to variations in the magnetic flux, and electric currents will be induced in a loop through which the varying magnetic flux passes. By cycling the temperature of the ferro- or ferrimagnetic material near or around the phase transition temperature in an applied magnetic field, and possibly also cycling the applied magnetic field, the magnetic flux through a loop may be made to vary cyclically, thus giving rise to an induced alternating current in the loop. This effect can be exploited in a thermomagnetic generator.

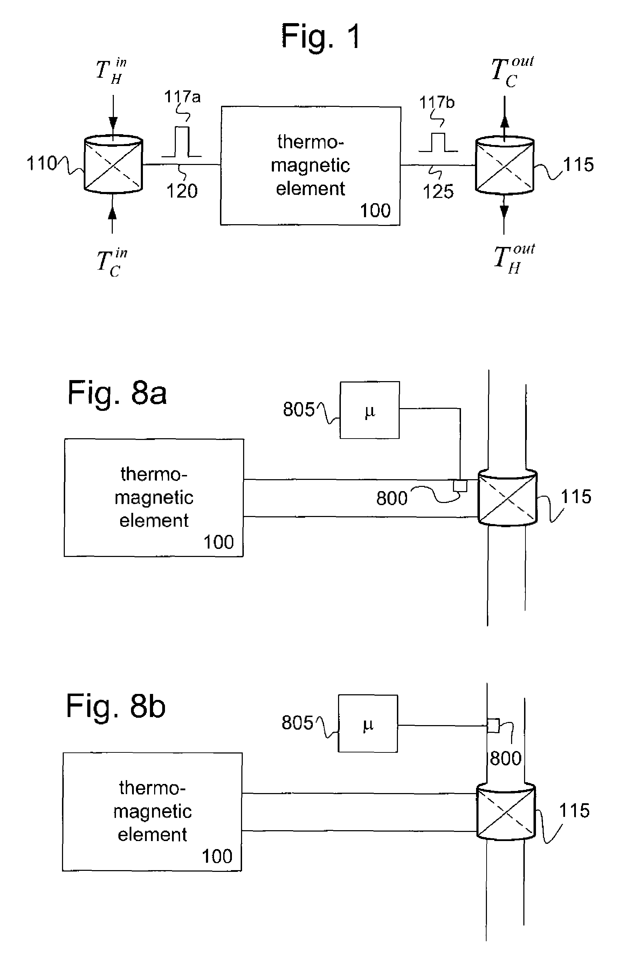

The temperature cycling of the thermomagnetic material can conveniently be achieved by means of passing a thermal fluid through or around the thermomagnetic material. **Fig. 1** schematically illustrates a thermomagnetic element 100, or element 100 for short. The element 100 of Fig. 1 comprises a material displaying a thermomagnetic phase transition at a temperature $T_{PT}$. The element 100 of Fig. 1 is connected to a fluid transportation system, whereby the temperature of the element 100 may be cycled. The fluid transportation system of Fig. 1 is arranged to let fluid flow unidirectionally through the thermomagnetic element 100, the fluid operating as a carrier of thermal energy to or from the thermomagnetic element 100, depending on the temperature difference between the fluid and the element 100. The fluid transportation system of Fig. 1 comprises an inlet valve device 110 connected to an inlet of the thermomagnetic element 100 and arranged to alternatively provide the thermomagnetic element 100 with heating fluid and cooling fluid of temperatures $T_H^{in}$ and $T_C^{in}$, respectively.

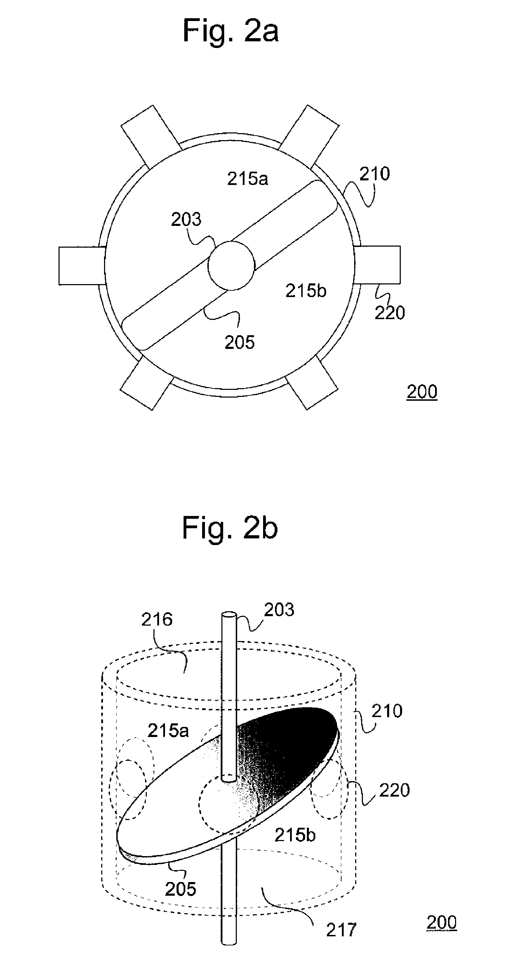

The inlet valve device 110 could for example be arranged to provide the element 100 with a unidirectional flow of fluid comprising heating and cooling fluid pulses. In Fig. 1, an indication of the temperature variations of a fluid entering the element 100 from the inlet valve device 110 is shown as a pulse train 117a represented by a square wave, while the outlet temperature variations of the fluid exiting the element 110 is shown as a pulse train 117a represented by a square wave of lower amplitude. The inlet valve device 110 could for example comprise a rotating valve as described in relation to Figs. 2a & 2b. Alternatively, the inlet valve device 110 could include a first valve connected to a cooling fluid inlet and a second valve connected to a heating fluid inlet, the first valve closing as the second valve opens, and vice versa. Other types of inlet valve devices may also be contemplated.

The fluid transportation system of Fig. 1 further comprises an outlet valve device 115 connected to a fluid outlet of the thermomagnetic element 100. The outlet valve device 115 can advantageously be arranged to separate the fluid flow of heating and cooling fluid pulses into a flow of heating fluid and a flow of cooling fluid of temperatures $T_H^{out}$ and $T_C^{out}$, respectively. An inlet valve device 110 and an outlet valve device 115 could for example be of the same design.

In Fig. 1, an inlet pipe 120 is shown to connect the inlet valve device 115 to the thermomagnetic element 100, and an outlet pipe 125 is shown to connect the thermomagnetic element 100 to the outlet valve device 115.

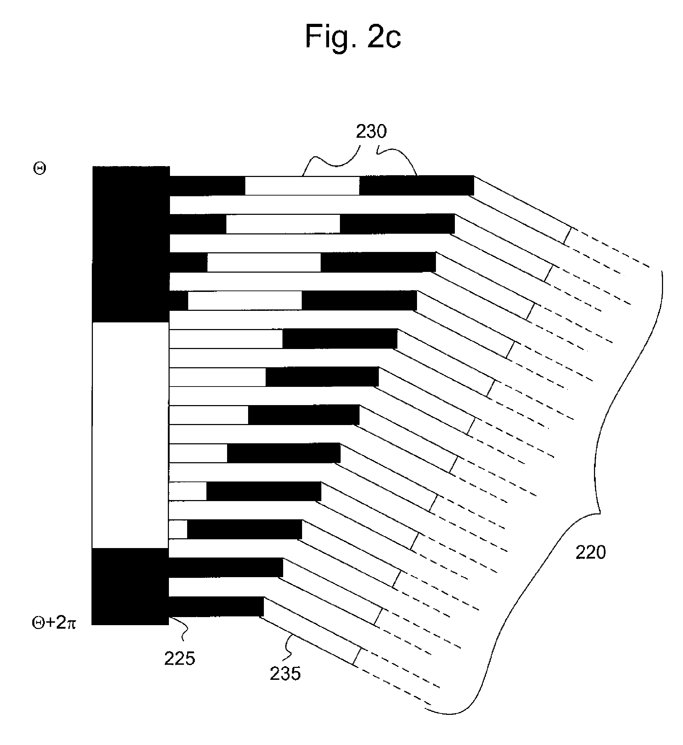

An example of a rotating valve 200 which could be used as an inlet valve device 110 or an outlet valve device 115 is schematically illustrated in Figs. 2a & 2b. Fig. 2a is a cross cut of a rotating valve 200, and Fig. 2b is a perspective view of the rotating valve 200 of Fig. 2a. The rotating valve 200 of Fig. 2 comprises a rotatable member 205 arranged on a rotatable shaft 203 which divides a hollow housing 210 into two different compartments 215a and 215b, the two compartments 215a and 215b respectively being arranged to be connected to a heating fluid inlet/outlet 216 and a cooling fluid inlet/outlet 217. Six fluid outlets/inlets 220 are arranged circumferentially on the housing 210 of rotating valve 200 of Figs 2a & 2b (when the rotating valve 220 is used as an inlet valve device 110, the outlets/inlets 220 will operate as fluid outlets, and vice versa). As the rotatable member 205 rotates when the rotating valve 200 is in operation, the outlets/inlets 220 will alternately be in contact with one of the two different compartments 215a/215b. Thus, when rotating valve 200 is used as an inlet valve device 110, the outlets/inlets 220 will alternately be provided with fluid from the cooling fluid inlet/outlet and the heating fluid inlet/outlet. The rotating valve 200 of Figs 2a & 2b is shown as an example only, and can be varied in many ways. For example, the number of outlets/inlets 220 may be smaller or greater than six; the rotatable member 205 may be of a different shape; and may be arranged to divide the hollow housing 210 into more than two compartments, etc.

In order to reduce pressure drops and losses in a rotating valve 200, an outlet/inlet 220 could comprise a plurality of sub-outlets/inlets 225. In order to obtain a desired phase synchronization of fluid delivered by different sub-outlet/inlets 225 of the same outlet/inlet 220, fluid paths 230 (for example pipes or channels) connected to different sub-outlet/inlets 225 of the same outlet/inlet 220 could be of different lengths, for example in a manner so that the difference in length between two fluid paths which are connected to adjacent sub-outlets/inlets 225 is $\dfrac{\lambda}{NM}$, where λ is length of a fluid pulse, N is the number of outlet/inlets 220 of the rotating valve 200, and M is the number of sub-outlets/inlets 225 of an outlet/inlet 220. Fig. 2c schematically illustrates fluid pulses 230 exiting a rotating valve 200 having one outlet/inlet 220 comprising twelve sub-outlets/inlets 225, wherein the rotatable member 205 divides the housing 110 into two compartments. Fig. 2c may be seen as a projection of the housing 210 and fluid paths 235 connected thereto. The black fields in Fig. 2c illustrate heating fluid, whereas the white fields illustrate cooling fluid (or vice versa). At a distance from the rotating valve 200 at which the desired phase synchronization of the sub-outlet/inlets 225 has been obtained, the fluid paths 235 connected to the different sub-outlet/inlets 225 of an outlet/inlet 220 can be joined to a single fluid path, if desired. In Fig. 2c, the fluid paths 235 connected to the sub-outlet/inlets 225 are made up of two straight pipes connected at a particular angle. However, this is for illustration purposes only, and a fluid path 235 could take any shape.

In order to enhance the efficiency of a thermomagnetic generator, thermomagnetic elements 100 can for example be designed in a manner so that the temperature of the thermomagnetic material can easily be altered. For example, a thermomagnetic element 100 could comprise a number of thin sheets, layers, or films of the thermomagnetic material, between which the heating and cooling fluid may be made to flow. By using thermomagnetic elements 100 in the shape of sheets, layers or films, laminar flow of the fluid may be achieved, which is often desirable since the flow of fluid through/around an element 100 is typically high. Good thermal contact between the an element 100 and the fluid may also be achieved by use of thermomagnetic elements 100 made of a porous thermomagnetic material, so that the heating and cooling fluid may be made to pass through the material; by use of an element 100 made of a homogenous material through which holes have been drilled, etc.

In order to enhance the efficiency of a thermomagnetic generator, the temperature range over which the temperature of an element 100 is cycled (here referred to as the working temperature region) could advantageously coincide with the temperature region for which the temperature gradient of magnetization is the largest. Typically, the working temperature region includes the phase transition temperature $T_{PT}$, although a working temperature which lies in the vicinity of $T_{PT}$ (below or above) could also be contemplated.

The center of the optimal working temperature region depends on the phase transition temperature, $T_{PT}$, of the magnetic material of element 100. Thus, in order to make efficient use of the thermal heat stored in the available heating fluid, one could arrange several elements 100 having different transition temperatures $T_{PT}$ in a series, so that heating fluid that has lost some of its heat while heating an element 100 of a higher transition temperature can be reused as heating fluid in an element 100 of lower transition temperature. Elements 100 having different phase transition temperatures can be achieved by use of for example YFeCo-based materials. For example, the Curie temperature of $Y_2(Fe_xC_{1-x})_{17}$ can be tailor made within the range from 324K to 1250K by varying the Fe-versus Co content. Another example of thermomagnetic materials the phase transition temperature of which can be tailor made is LaFeCo-based materials. Yet other thermomagnetic materials could also be used.

A series of thermomagnetic elements arranged so that a heating fluid outlet from an element having a higher transition temperature is connected to a heating fluid inlet of an element having a lower transition temperature, and so that a cooling fluid outlet from an element having a lower transition temperature is connected to a cooling fluid inlet of an element having a higher transition temperature will hereinafter be referred to as a cascaded series, or a cascade, of thermomagnetic elements. The connection between a heating/cooling fluid outlet of a first element to a heating/cooling fluid inlet of a second element does not have to be direct, but other equipment could be connected in between, such as for example one or several valve devices.

By using elements 100 having different phase transition temperatures in the temperature interval of 0-100°C, water may advantageously be used as a heating/cooling fluid and thus as a means of thermal transport. Thermal waste energy from processes such as nuclear energy production, combustion energy production, pulp and paper manufacturing, etc., as well as geothermal energy, ocean thermal energy, solar energy and so forth, may thus conveniently be converted into electrical energy. However, other fluids may alternatively be used as a means of thermal transport.

The phase transition temperatures of the different elements 100 of a cascade could for example be distributed so that the phase transition temperature difference between two adjacent elements 100 in a cascade equals the average temperature increase/decrease $\delta T$ of the fluid in an element 100 upon operation.

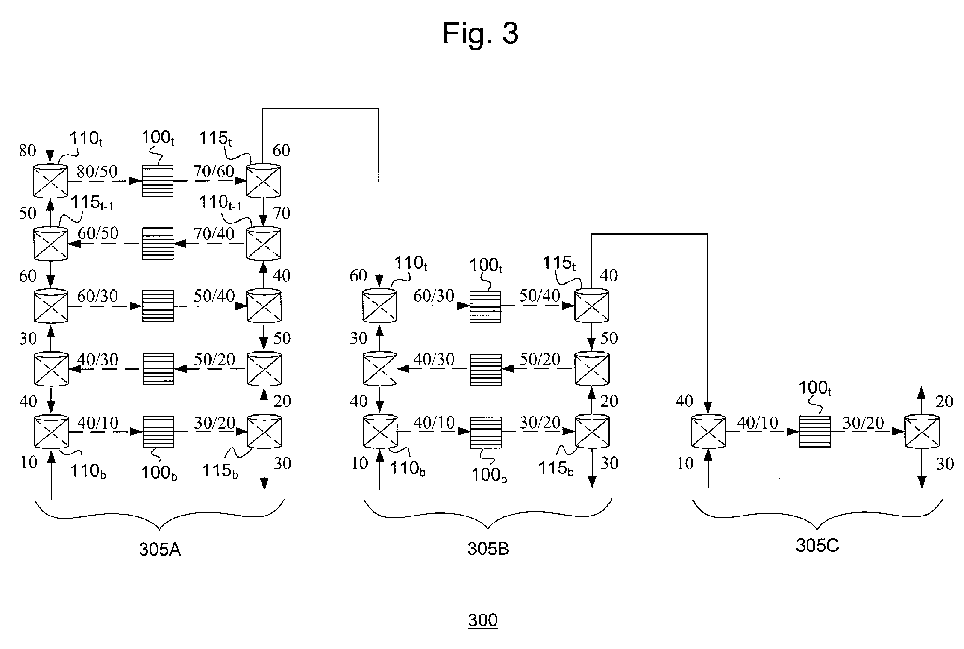

**Fig. 3** illustrates a system 300 of thermomagnetic elements 100 having different phase transition temperature arranged in a multi-cascade system. The system 300 of Fig. 3 comprises nine elements arranged in a first cascade 305A, a second cascade 305B and third cascade 305C, wherein the element having the highest transition temperature is arranged at the top of the cascade, and so forth. The first cascade 305A of Fig. 3 includes five elements. (The total number of elements in a system 100, M, and the number of elements 100 in the longest cascade, N, have in Fig. 3 been set M=9 and N=5 for purposes of illustration only, and M and N can generally take any number larger than 1). The top element of a cascade is here denoted $100_t$, and the bottom element is denoted $100_b$. In the example of Fig. 3, the initial heating fluid is set to temperature $T_H = 80$ °C, the temperature difference between heating and cooling fluid over an element is $\Delta T=30$ °C, the initial cooling temperature is $T_C = 10$ °C and the temperature increase/decrease over an element 100 is $\delta T = 10$ °C. These temperatures are given as an example for illustration purposes only, and should not be construed as limiting in any way.

The terms "top", "bottom", "next up" and "next down" etc. in the present discussion refer to the relative position of the elements 100 of a cascade 305/405 in the temperature loop. Thus, an element 100 that is higher up in a cascade 305/405 has a transition temperature that is closer to the highest transition temperature of the system 300/400, and vice versa. The terms do not refer to a relative geographical location.

Each thermomagnetic element 100 in system 300 is connected to an inlet valve device 110 and an outlet valve device 115, cf. Fig. 1. The bottom element $100_b$ of the first cascade 305A of Fig. 3 is arranged to receive cooling fluid of temperature $T_C$ from an external source (not shown). When this fluid passes through element $100_b$, the fluid gains some heat from element $100_b$, and the fluid exits element $100_b$ at a temperature $T_C+\delta T$, where $\delta T$ denotes the temperature

increase of the fluid in element $100_b$. The fluid of temperature $T_C+\delta T$ is then used as inlet cooling fluid to the next element up, element $100_{b+1}$, in the first cascade 305A, in which the fluid again gains some heat and exits at temperature $T_C+2\delta T$ (here assuming that the temperature decrease is the same in all elements 100, which does not have to be the case). The fluid of temperature $T_C+2\delta T$ is used as inlet cooling fluid to the next element $100_{b+2}$ in the first cascade, etc.

In the system 300 of Fig. 3, the cooling fluid outlet of the outlet valve device $115_t$ of the top element $100_t$ of the first cascade 305A is connected to the heating fluid inlet of the inlet valve device $110_t$ of the top element $100_t$ of the second cascade 305B. Hence, the cooling fluid, which entered cascade 305A at temperature $T_C$ and upon exit from cascade 305A has reached a temperature of $T_C+N\delta T$, can be used as heating fluid to be fed to the top element $100_t$ of cascade 305B. In this manner, heat gained by the cooling fluid in the first cascade can be reused in the second cascade, etc.

Similarly, the top element $100_t$ in the first cascade 305A is arranged to receive heating fluid of temperature $T_H$ from an external source (not shown). When fluid passes through element $100_t$, the fluid loses some of its heat to element $100_t$, and the fluid exits element $100_t$ at a temperature $T_H-\delta T$, where $\delta T$ denotes the temperature decrease of the fluid in element $100_t$. The fluid of temperature $T_H-\delta T$ is then used as inlet heating fluid to the next element down in the first cascade 300A, element $100_{t-1}$, in which the fluid again loses some of its heat and exits at temperature $T_H-2\delta T$. The fluid of temperature $T_H-2\delta T$ is used as inlet heating fluid to the next element $110_{t-2}$ down in the first cascade 305A, etc.

Although not shown in Fig. 3, a heating fluid outlet of the outlet valve device $115_b$ of the bottom element $100_b$ of the first cascade 305A can be connected to the inlet valve device $110_b$ of the bottom element $100_b$ of the second cascade 305B. Hence, the heating fluid, which initially entered cascade 305A at temperature $T_H$ and which upon exit from cascade 305A has reached a temperature of $T_H-N\delta T$, can be used as cooling fluid to be fed to the bottom element $100_b$ of cascade 305B. In this manner, cooling power gained by the heating fluid in the first cascade can be re-used in the second cascade, etc. However, in situations where there is an abundance of cooling fluid, the recuperation of the initially hot fluid as cooling fluid in a subsequent cascade 305 may be superfluous. In system 300 of Fig. 3, for example, each cascade 305 in the system 300 is fed cooling fluid at a temperature $T_C$ from an external source.

As shown in Fig. 3, fluid used as cooling fluid through a cascade 305 is reused as the heating fluid in the subsequent cascade 305 of system 300. Similarly, fluid used as heating fluid through a cascade 305 may be reused as the cooling fluid in the subsequent cascade 305. The top element 100 of a subsequent cascade 305 of a multi-cascade system 300 typically has a transition temperature that is lower than the top element 100 of a preceding cascade 305. If a preceding cascade 305 has N elements 100, the subsequent cascade 305 could for example have N-2 elements 100.

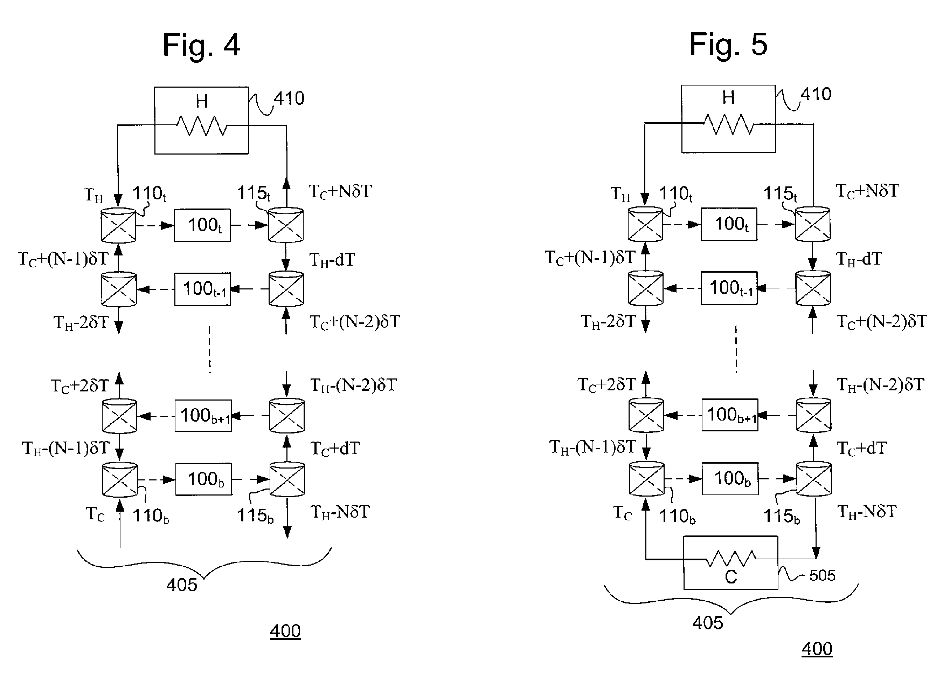

**Fig. 4** shows a system 400 of thermomagnetic elements 100 arranged in a single cascade 405. The cascade 405 includes N elements, where N can generally take any number larger than 1. The top element of cascade 405 is denoted $100_t$, and the bottom element is denoted $100_b$.

An inlet valve device $110_t$ of cascade 405 of Fig. 4 is arranged to receive a heating fluid of temperature $T_H$. As in the system 300 of Fig. 3, a heating fluid outlet of an outlet valve device 115 of an element 100 (not being the bottom element $100_b$) is connected to a heating fluid inlet of an inlet valve device 110 of the next element 100 down in the cascade 405, so that upon operation of the system 400, the heating fluid which exits from an element 100 of cascade 405 may be returned to the system 400 as the heating fluid which is inlet to the next element down in the cascade 405. Similarly, a cooling fluid outlet of an outlet valve device 115 of an element 100 (not being the top element $100_t$) is connected to a cooling fluid inlet of an inlet valve device 110 of the next element 100 up in the cascade 405, so that the cooling fluid which exits from an element 100 of cascade 405 may be returned to the system 400 as the cooling fluid of the next element 100 up in the cascade 405.

As opposed to the system 300 of Fig. 3, the outlet of cooling fluid from the top element $100_t$ of cascade 405 is not connected to a further cascade. Upon leaving the top element $100_t$, such cooling fluid will have reached a temperature $T_C+N\delta T$. A cooling fluid outlet of top element $100_t$ of system 400 is connected to a heat source 410 from which the external heating fluid supply is being fed. Thus, the heat gained by the cooling fluid in the cascade 405 will, at least indirectly, be returned to the cascade 405.

The heat source 410 could be a conventional heat exchanger, where the cooling fluid exiting the top element $100_t$ could be returned as heating fluid to the inlet valve device $110_t$ of the top element $100_t$ in a closed loop. Alternatively, the heat source 410 could be an open system, such as a geothermal hot water resource, a waste water depot comprising cooling water from a power plant or manufacturing industry, etc, to which the cooling fluid from the top element $100_t$ is returned, and from which the heating fluid fed into the top element $100_t$ is provided.

Another embodiment of a single cascade system of thermomagnetic elements 100 is illustrated in **Fig. 5**. System 500 of Fig. 5 comprises a single cascade 405 comprising N elements 100, which are connected by inlet and outlet valve devices 110 and 115 in the cascaded manner described in relation to Fig. 4. However, in addition to being connected to the heat source 410 of Fig. 4, the cascade 405 is further connected to a heat sink 505 via the heating fluid outlet of the bottom element $100_b$. The heat sink 505 operates to reduce the heat content of any received fluid, and to outlet the fluid at temperature $T_C$. Thus, by connecting the cooling fluid inlet of cascade 405 to the outlet of the heat sink 505, the cooling power gained by the heating fluid in the cascade 405 can be recuperated in the cooling fluid of system 500.

The heat sink 505 could for example be a conventional closed loop heat exchanger, or an open loop heat exchanger such as a cold water depot, etc.

Also in the system 300 of Fig. 3 could the heating fluid outlet of the lowermost outlet valve device 115$_b$ of a cascade 305 be connected to a heat sink 505 in order to further cool the used heating fluid. An outlet of the heat sink 505 could then for example be connected to the cooling fluid inlet of the lowermost inlet valve device 110$_b$ of the next cascade 305 in the system 300.

In Figs. 3, 4 and 5, the fluid transportation system by means of which the temperature of the elements 100 of systems 300/400 may be controlled comprises the inlet valve devices 110, the outlet valve device 115 and pipes transporting the heating/cooling fluid to and from the thermomagnetic elements 100. The valve devices 110 and 115 could for example be rotating valve devices (cf. Fig. 2), arranged to supply the elements 100 with a flow of heating and cooling fluid pulses. Rotating valves 200 are well suited for industrial amounts of fluid, since by using such rotating valves, the fluid flow does not have to be stopped, reversed or re-directed, but a continuous fluid flow may be obtained, in a manner so that the flow through an element 100 is uni-directional. However, as discussed above in relation to Fig. 1, other types of valve devices may alternatively be used.

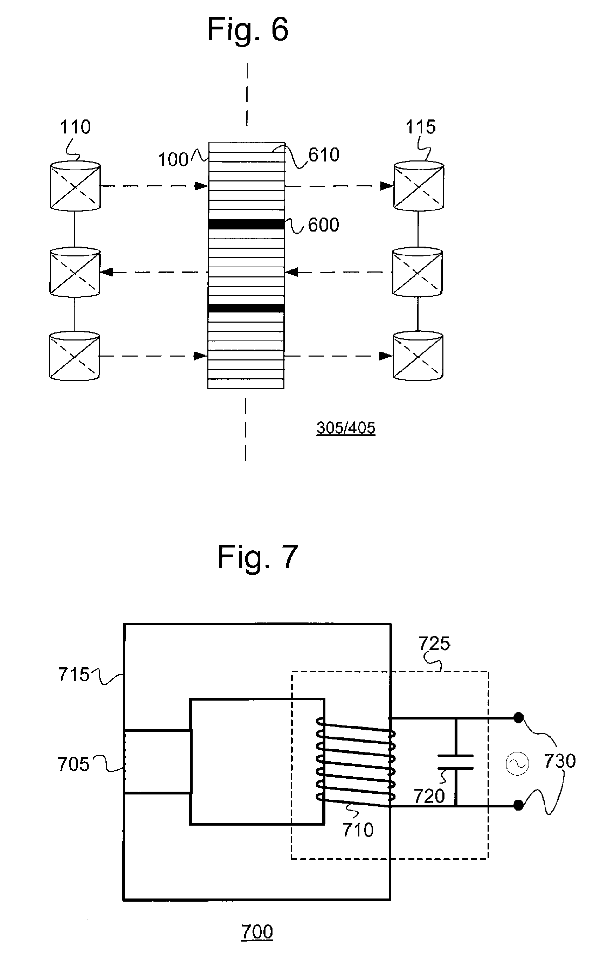

Although in Figs 3 and 4 the elements 100 in a cascade 305/405 are shown to be arranged so that there is a gap between the different elements, this is for illustration purposes only. The different elements within a cascade 305/405 could alternatively be arranged directly next to each other, or separated for example by means of a material having high permeability, in order to efficiently guide the magnetic flux in a desired direction. An example of a suitable material for separating the elements 100 is electrical steel, which has high permeability and small hysteresis area. A cascade 305/405 wherein two elements 100 are separated by a separator 600 is shown in **Fig. 6**. The use of separators 600 in a cascade may simplify the construction of a cascade 305/405. The elements 100 of Fig. 6 is shown to comprise nine sheets 610 of thermomagnetic material. However, an element 100 comprising sheets of thermomagnetic material could include any number of sheets, for example in the order of thousands. As discussed above, the use of sheets or layers is an example of one of several possible designs of an element 100, and the elements 100 could alternatively be designed in another manner.

**Fig. 7** schematically illustrates a thermomagnetic generator 700 for converting thermal energy into electrical energy by means of thermomagnetic material. The generator 700 of Fig. 7 comprises a thermomagnetic system 705 and a coil or winding 710 arranged so that a change in the magnetization of the thermomagnetic system 705 will result in a change in the magnetic flux through the coil 710. An external magnetic field may for example be provided by a permanent magnet or an electromagnet, where an electromagnet may or may not include the coil 710. The thermomagnetic system 705 could include a cascaded system 300/400 of thermomagnetic elements 100 illustrated in Figs. 3, 4 and 5. The thermomagnetic system 705 could for example be arranged to form a magnetic circuit 715 in conjunction with a material of high permeability in the temperature region wherein the heating and cooling fluids provide temperature variations. The coil 710 could be wound around the magnetic circuit 715. The coil 710 could for example be connected in parallel to a capacitor 720 to form a resonant electrical circuit 725, wherein the frequency of the temperature variation of the thermomagnetic elements 100 of the thermomagnetic system 705 and the resonant frequency of the resonant electrical circuit 725 could be selected so as to optimize the resonant energy transfer to the resonant electric circuit 725. In operation of generator 700, an AC voltage will be generated over connectors 730 connected over the coil 710. The thermomagnetic generator 700 in Fig. 7 is given as an example only, and alternative designs of a thermomagnetic generator 700 may be used.

By connecting a plurality of thermomagnetic elements of different transition temperatures into at least one cascade as shown in Figs. 3, 4 and 5, the efficiency of the electric power generation provided by the thermomagnetic elements 100 can be improved. The efficiency $\eta$ of a system can generally be defined as:

$$\eta = \frac{W_{out}}{Q_{in}} \tag{1},$$

where $Q_{in}$ is the heat supplied to the system 300, and $W_{out}$ is the work extracted from the system 300.

Let the efficiency of a single thermomagnetic element 100 be denoted $\eta_s$. Let $Q_{in}$ denote an amount of (heat) energy supplied to a system of thermomagnetic elements 100. If the thermomagnetic elements are arranged as single thermomagnetic elements 100 (cf. Fig. 1), the amount of (electric) work extracted from the system will equal $\eta_s Q_{in}$.

In the following, the efficiency $\eta_{multicascade}$ of a thermomagnetic system 705 comprising a multi-cascade system 300 of thermomagnetic elements will be estimated (cf. Fig. 3), as will the efficiency $\eta_{singlccascade}$ of a thermomagnetic system 705 comprising a single cascade system 400 of thermoelectric elements 100, wherein a single cascade 405 is connected to a heat source 410 (cf. Fig. 4). The estimations given below are low efficiency estimations - when the efficiency of the thermomagnetic arrangement approaches the Carnot efficiency, other factors should be taken into account in order to arrive at a good estimation.

The efficiency $\eta_{multicascade}$ of a thermomagnetic generator wherein a first cascade 305 is followed in series by the maximum number of cascades 305 possible while maintaining a desired temperature difference $\Delta T$ between the heating and cooling fluid over an element 100 can be derived as follows.

Consider the following notation:

$T_H$    heating fluid initial temperature (before entering the topmost element of the longest cascade)
$T_h$    heating fluid final temperature (after exiting the bottommost element of the longest cascade)
$T_C$    cooling fluid initial temperature (before entering the bottommost element of the longest cascade)
$T_c$    cooling fluid final temperature (after exiting the topmost element of the longest cascade)
$\Delta T$    heating-cooling fluid temperature difference for an element 100
$\delta t$    fluid temperature increase or decrease, respectively, over an element 100
N    number of elements in the longest cascade ( $\approx [(T_H\text{-}T_C)/\delta T\text{-}n]$)
M    total number of elements in the system 300
n    parameter of value $[(\Delta T\text{-}\delta t)/ \delta t]$, $n \geq 1$
$m_f$    fluid mass flow
$C_f$    fluid specific heat,
$\eta_s$    efficiency of a single element 100

Assuming approximately equal working conditions at all temperature levels and the same $\eta_s$ efficiency for all thermomagnetic elements 100 of the system 300, while neglecting thermal losses, the heat supplied to the system can be described as:

$$Q_{in} = m_f \cdot C_f \cdot (T_H - T_h) = m_f \cdot C_f \cdot N \cdot \delta T \qquad (2).$$

Assuming, for simplicity of calculation, that n is an integer, the work extracted from the system can be described as:

$$W_{out} = \eta_s \cdot m_f \cdot C_f \cdot \delta T \cdot M =$$

$$= \eta_s \cdot m_f \cdot C_f \cdot \delta T \cdot [N + (N - n) + (N - 2n) + \cdots] \approx$$

$$\approx \eta_s \cdot m_f \cdot C_f \cdot \delta T \cdot [\frac{N(N+n)}{2n}] \qquad (3).$$

wherein the sum in the middle term of the expression includes the terms for which (N-xn) is positive, x being a positive number. Hence, the efficiency of the system 300 of Fig. 3 can be estimated by use of the following expression:

$$\eta_{multicascade} = \frac{Q_{in}}{W_{out}} \approx \left[\frac{(N+n)}{2n}\right] \eta_s \qquad (4).$$

As can be seen from expression (4), for configurations of system 300 wherein N>n, the efficiency of the system 300 is increased as compared to the efficiency of single elements 100 operated at a heating-cooling fluid temperature difference $\Delta T$.

The efficiency $\eta_{singlecascade}$ of a system 400 comprising a single cascade 405 can be estimated as follows. The heat provided to the system 400 (neglecting any heat losses) is given by the difference between the heat of the cooling fluid outlet from the top element $110_t$ and the heat of the heating fluid inlet to the top element $110_t$:

$$Q_{in} = m_f \cdot C_f \cdot (T_H - T_c) =$$

$$= m_f \cdot C_f \cdot (\Delta T - \delta T) = m_f \cdot C_f \cdot n \cdot \delta T \qquad (5).$$

The work extracted from the system equals the work extracted from the N elements of the cascade 405 (in this configuration, M=N):

$$W_{out} = \eta_s \cdot N \cdot m_f \cdot C_f \cdot \delta T \qquad (6).$$

Thus, the efficiency of a system 400 is given by:

$$\eta_{singlecascade} = \frac{W_{out}}{Q_{in}} = \frac{N}{n} \eta_s \qquad (7).$$

It can be seen from expressions (4) and (7) that the efficiency of the single cascade system 400 is larger than the efficiency of the multi-cascade system 300 for N>n. Hence, although the efficiency of the multi-cascade system 300 exceeds the efficiency of a single element, the efficiency of a single cascade system 400 is even higher. Thus, by using a multicascade system 300 in a thermomagnetic generator 700, or a single cascade system 400, the efficiency of the generator 700 can be improved.
It can be derived from expressions (4) and (7) that the efficiency of a cascaded system of thermomagnetic elements 100 is higher than the efficiency of a single element 100 if:

$$N > n = \frac{\Delta T}{\delta T} - 1 \qquad (8),$$

where N is the number of elements 100 in (the longest) cascade. It can further be derived from expressions (4) and (7), that the larger the difference between N and n, the higher the efficiency of cascade. For $\Delta T = \delta T$, the value of the parameter n would be zero, and hence, N would be larger than n for any system. However, in a system wherein the temperature difference ($\Delta T$) between heating and cooling fluid over an element 100 is of the same magnitude as the temperature decrease/increase ($\delta T$) of the heating/cooling fluid in the element 100 would be inefficient, since no difference between the heating and cooling phases of the operation of the thermomagnetic generator would arise. Hence, in order to efficiently separate the cooling phase from the heating phase of an element 100, the temperature difference ($\Delta T$) between the heating and cooling fluid over an element 100 could for example be at least twice the magnitude of the temperature increase/decrease ($\delta T$) of the cooling/heating fluid in the element 100, i.e. $\Delta T$ could be equal to, or larger than, $2\delta T$.
In an example wherein there are five thermomagnetic elements 100 in a single cascade 405 of a system 400 (N=5); the heating-cooling fluid temperature difference for an element 100 is 30°C ($\Delta T$=30°C); and the fluid temperature increase/decrease over an element 100 is 10°C ($\delta t$=10°C), the efficiency of the system 400 is approximately 2.5 times that of a single thermomagnetic element 100, $\eta_{singlecascade} \approx 2.5 \, \eta_s$. For a multi-cascade system 300 where there are five thermomagnetic elements 100 in the longest cascade, and wherein $\Delta T$=30°C and $\delta t$=10°C, the efficiency of the system 300 is approximately 1.75 times that of a single thermomagnetic element 100, $\eta_{multicascade} \approx 1.75 \, \eta_s$.
As mentioned above, the estimates of the efficiency of a single cascade system 300 and a multi-cascade system 400 represented by expressions (4) and (7) are low-efficiency estimations. However, it can be shown that both the single cascade efficiency and the multi-cascade efficiency is higher than the efficiency of a single element 100, $\eta_s$, for all N/n>1, and that $\eta_{singlecascade}$ is higher than $\eta_{multicascade}$ for all values of N/n>1. It can further be shown that the efficiency of a single cascade approaches the Carnot efficiency $\eta_C$ for large values of N/n:

$$\eta_{singlecascade} = \frac{N}{n}\eta_s = \frac{T_H - T_h}{\Delta T - \delta T}\eta_s \leq \frac{T_H - T_h}{\Delta T_m}\eta_s \approx$$

$$\approx \Delta S \frac{T_H - T_h}{\Delta S \cdot T_H + C_m \Delta T_m} \leq \frac{T_H - T_h}{T_H} = \eta_C \qquad (9),$$

where $\Delta S$ is the change in entropy of an element 100 during temperature cycling, $C_m$ is the (average) heat capacity of the thermomagnetic material of an element 100 and $\Delta T_m$ is the difference between the highest and lowest temperature of the thermomagnetic material of an element 100.

In a cascade 305/405 wherein the temperature range over which the phase transition takes place is wider for some elements 100 of the cascade 305/405 than for others, the system 300/400 could for example be arranged in a manner so that during operation of the system 300/400, the temperature increase/decrease of an element 100 in a cascade 305/405 will be greater for elements 100 displaying a wider phase transition than for elements 100 displaying a narrower phase transition. In this manner, the great part, if not all, of the width of the optimal working temperature region of all elements 100 of a cascade 305/405 could be efficiently exploited, and the efficiency of the system 300/400 could thereby be increased. The width of phase transition of an element 100 typically depends on the phase transition temperature of the element 100, and is generally wider for elements 100 having a higher phase transition temperature.

A difference in temperature increase/decrease between different elements 100 in a cascade 305/405 could be achieved in different ways. When an element 100 comprises a number of sheets or layers, the thickness of the sheets or layers could for example be smaller in elements 100 displaying a wider phase transition than in elements 100 displaying a narrower phase transition, so the temperature change caused by a fluid pulse flow in a wider-phase-transition element 100 will be greater than in a narrow-phase-transition element 100. A difference in temperature increase/decrease between elements 100 in a cascade 305/405 could also be achieved by applying a coating to the elements 100 in a manner so that a coating of an elements 100 displaying a narrower phase transition has a smaller heat transfer coefficient than a coating for elements 100 displaying a wider phase transition. Where the same coating material is used for all elements 100, a thinner (or no) coating could be applied to an element 100 displaying a wide phase transition. Yet another way whereby a difference in temperature increase/decrease between elements 100 in a cascade 305/405 could be achieved is by use of different switching frequencies for different elements 100, so that shorter heating/cooling pulses are used for elements 100 displaying a narrower phase transition.

The elements of a thermomagnetic system 300/400 can for example serve the same electrical phase of a generator 700. This simplifies synchronisation of the valve devices, as well as fluid flow control. When the valve devices 110/115 of system 300/400 are rotating valves 200 as discussed above, an valve device 110/115 could for example have one outlet/inlet 220 per electrical phase of the generator, where elements 100 serving different phases are part of different systems 300/400. The angular separation of the outlets 220/inlets in housing 210 could then correspond to the angular separation of the electrical phases.

Elements of the same thermomagnetic system 300/400 may alternatively serve different electrical phases of a generator 700. The elements 100 of a system 300/400 could for example be displaced relative to each other in a manner so that the heating and cooling cycles of the elements 100 will be phase-shifted relative to each other, thus giving rise to different electrical phases; or different inlet valve devices 110 of system 300/400 could be arranged to generate heating/cooling fluid pulse trains of different phases. If the elements of the same thermomagnetic system 300/400 are magnetically separated (e.g. do not share the same magnetic circuit, cf. magnetic circuit 715 of Fig. 7), the inlet valve devices 110 serving different elements 100 could generate pulse trains of different frequencies, if desired.

Synchronization of the valve devices 110/115 typically improves the efficiency of a generator 700 comprising thermomagnetic elements 100 arranged in a cascade 305/405. Synchronization of the inlet valve devices 110 connected to elements 100 serving the same electrical phase can be used to ensure that the changes in the magnetization occur simultaneously in all the elements 100 serving the same electrical phase. Synchronization of inlet valve devices 110 of elements 100 serving different electrical phases can be used to ensure that the phase difference between the electrical phases stays intact. Synchronization between inlet and outlet valve devices 115 serving the same element 110 can be used to ensure that the separation of the heating and cooling pulses from an element is optimized, thus optimizing the heating/cooling powers of the fluid at all elements of a cascade 305/405.

Synchronization of the outlet valve device 115 and an inlet valve device 110 of an element 100 can for example be achieved by means of a temperature sensor 800 in the fluid flow on the exit side of the element 100, see Fig. 8a and 8b. In **Fig. 8a**, the temperature sensor 800 is arranged in the fluid flow before the outlet valve device 115, i.e. between the element 100 and the outlet valve device 115. The temperature sensor 800 is connected (by wire or wirelessly) to a processor 805, which may be a conventional microprocessor or other processing means. The temperature sensor 805 is arranged to send a signal to the processor 805 upon detection of a triggering event, which triggering event could for example be the detection of a temperature raise, or a temperature drop, of the fluid, the temperature raise or drop representing the beginning of a heating fluid pulse or a cooling fluid pulse, respectively. The processor can be arranged to determine the desired phase and/or frequency of the fluid separation mechanism in outlet valve device 115 in response to the signal(s) received from the temperature sensor 800, and to instruct the outlet valve device 115 of any required changes to the phase and/or frequency of the fluid pulse separation by means of a wired or wireless connection (not shown). The desired phase depends on the location of the temperature sensor 800 relative to the outlet valve device 115, as well as on the frequency of the fluid pulses.

In Fig. 8b, the temperature sensor 800 is instead located after the outlet valve device 115, in a heating or cooling fluid outlet of the outlet valve device 115. The temperature sensor 800 is also in this configuration arranged to send a signal to processor 805, where the signal is indicative of the temperature of the fluid in the heating/cooling fluid outlet. The processor 800 can be arranged to, based on the signals received from the temperature sensor, control the phase and/or frequency of the fluid pulse separation mechanism in the outlet valve device 115 in a manner so that the temperature of the heating fluid in the heating fluid outlet is maximised (or the temperature of the cooling fluid in the cooling fluid outlet is minimised).

A combination of the configurations illustrated in Figs. 8a and 8b may be used, or one of the configurations could be used separately to control the operation of an outlet valve device 115.

The mechanisms for improving the synchronisation of fluid pulse separation in the outlet valve device 115 illustrated in Figs. 8a and 8b will be useful also in generators 700 wherein the thermomagnetic system 705 is a single thermomagnetic element 100, cf. Fig. 1.

When the fluid pulse generation in an inlet valve device 110 is performed by means of a rotating member, as in the rotating valve device of Fig. 2, the synchronization of valve devices can alternatively be performed by attaching the rotating members of the valve devices to be synchronized on the same rotating shaft - with or without a phase shift, depending on whether or not a phase shift is required.

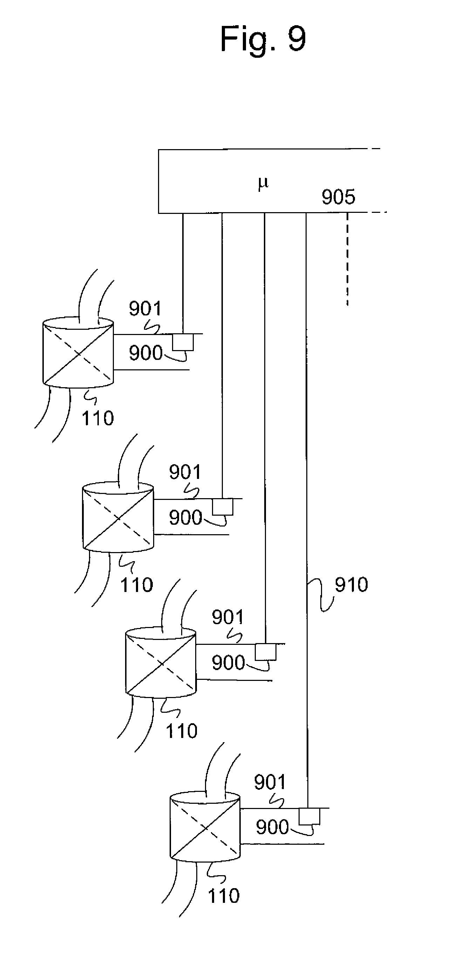

In Fig. 9, an example of a synchronisation mechanism for the synchronisation of inlet valve devices 110 serving different elements 110 in a cascade 205/305 is illustrated. In the fluid pulse outlet 901 from each of the inlet valve devices 110 of Fig. 9 is mounted a temperature sensor 900, which is arranged to detect any triggering event, such as a temperature raise or drop in the fluid in the fluid pulse outlet 901, and to send a signal in response to the detection of a triggering event to a processor 905 via a connection 910 (which may be wired or wireless). The processor is arranged to detect any differences in the triggering times of the different temperature sensors 900, and to instruct the relevant inlet valve device(s) to adjust the phase and/or frequency of the fluid pulse generation in order to minimize the difference in triggering times (the instructions can be sent over a wired or wireless connection (not shown) between the processor 905 and the inlet valve devices 115). The processor 905 may be the same, or different, physical processor as processor 805.

Each temperature sensor 900 can for example be located at the same distance from the inlet valve device 110 it is serving, so that the synchronization process becomes independent of fluid pulse frequency for temperature sensors 900 serving the same electrical phase (assuming the same pulse generation frequency of all inlet valve devices 110). For synchronization of temperature sensors 900 used in the control of inlet valve devices 110 serving different electrical phase, the processor 905 can be arranged to determine the actual phase shift from the occurrence of the triggering pulses, and to adjust the pulse generation so that the phase shift is constant between adjacent phases.

By applying a continuous flow of pulses through an element 100 as described above, the variations in pressure in the fluid transportation system are minimised. However, a fluid transportation system whereby a set if discontinuous pulses of alternately heating fluid and cooling fluid is fed through an element 100 may alternatively be used. This may for example be the case if the inlet valve devices 110 are of a conventional valve type.

Recuperation of heat in a cascade 305/405 of thermomagnetic elements 100 as described above can significantly improve the efficiency of a thermomagnetic generator 700. Improved efficiency of a thermomagnetic generator 700 will for example result in less consumption of source heat, higher delivered electrical power and/or utilization of smaller sources of thermomagnetic materials. Moreover, the economic efficiency of the power generation can be even further reduced in that external heat sinks and/or heat sources (cf. heat source 410 and heat sink 505) can be made smaller, cheaper and with reduced pump demands as the conversion efficiency of the system of thermomagnetic elements increases.

By use of a cascaded system 300/400 of thermomagnetic elements 100, wider temperature ranges may be exploited, and higher-grade thermal sources might be considered for the conversion of thermal energy into electrical energy by use of materials displaying a magnetic phase transition.

Although the above description has been made in terms of thermomagnetic materials, the aspects disclosed in the description apply equally well to electrical power generation by means of thermoelectric materials. In this embodiment, the thermomagnetic elements 100 of the above description would be replaced by thermoelectric elements, and the applied magnetic field would be replaced by an applied electric field. A generator arrangement for converting thermal energy into electrical energy by means of thermoelectric materials is disclosed for example in patent application WO2000/36656.

Although various aspects of the invention are set out in the accompanying independent claims, other aspects of the invention include the combination of any features presented in the above description and/or in the accompanying claims, and not solely the combinations explicitly set out in the accompanying claims.

One skilled in the art will appreciate that the technology presented herein is not limited to the embodiments disclosed in the accompanying drawings and the foregoing detailed description, which are presented for purposes of illustration only, but it can be implemented in a number of different ways, and it is defined by the following claims.

**Claims**

1. An arrangement for converting thermal energy into electric energy comprising:

   at least two thermomagnetic elements (100); and
   inlet valve devices and outlet valve devices, an element being connected between an inlet valve device and an outlet valve device; wherein:

   an element comprises a material exhibiting a magnetic phase transition, the phase transition of the elements being at different temperatures;
   the at least two elements are arranged in at least one cascaded series (305; 405) in a manner so that:

   a cooling fluid inlet of the inlet valve device of an element having a phase transition temperature higher than the lowest phase transition temperature of the cascaded series is arranged to receive cooling fluid from a cooling fluid outlet of an outlet valve device of an element having a lower phase transition temperature; and
   a heating fluid inlet of the inlet valve device of an element having a phase transition temperature lower than the highest phase transition temperature of the cascaded series is arranged to receive heating fluid from a heating fluid outlet of an outlet valve device of an element having a higher phase transition temperature.

2. The arrangement of claim 1 wherein the at least one cascaded series is a single cascaded series of thermomagnetic elements, wherein
   a cooling fluid outlet of an outlet valve device of an element having the highest transition temperature of the cascaded series is connected to an inlet of a heat source arranged to heat fluid received at said inlet, and wherein an outlet of the heat source is connected to a heating fluid inlet of an inlet valve device of the element having the highest transition temperature.

3. The arrangement of claim 1, wherein the at least one cascaded series is at least two cascades series, wherein
   a cooling fluid outlet arranged to deliver cooling fluid from the element having the highest transition temperature of a first cascaded series is connected to a heating fluid inlet serving the element having the highest transition temperature of a second cascaded series.

4. The arrangement of any one of claims 1-3, wherein:

   an inlet valve device has a heating fluid inlet for receiving a flow of heating fluid, a cooling fluid inlet for receiving a flow of cooling fluid, and an outlet (901) for delivering, to an element, a unidirectional fluid flow comprising heating and cooling fluid pulses; and
   an outlet valve device has an inlet for receiving, from an element, a fluid flow comprising heating and cooling fluid pulses; the outlet valve device being arranged to separate received heating and cooling fluid pulses into a flow of cooling fluid and a flow of heating fluid; the outlet valve device further having a heating fluid outlet for delivering a flow of heating fluid, and a cooling fluid outlet for delivering a flow of cooling fluid.

5. The arrangement of any one of claims 1-3, wherein
   an inlet valve device comprises a rotatable member for generation of a unidirectional fluid flow of heating and cooling fluid pulses, the rotatable member being arranged to separate a heating fluid inlet of the valve device from a cooling fluid inlet of the valve device, and to alternately separate an outlet of the valve device from the heating fluid inlet and the cooling fluid inlet.

6. The arrangement of claim 5, wherein
rotatable members of different inlet valve devices are arranged on the same rotating shaft.

7. The arrangement of any one of claims 4-6, wherein
an inlet valve device is arranged to serve more than one element, said more than one element serving the same or different electrical phases.

8. The arrangement of any one of the claims 4-7, further comprising
a temperature sensor (900) in the outlet (901) of at least two inlet valve devices, a temperature sensor being arranged to generate a triggering signal upon detection of a triggering event in the flow of fluid pulses; and
a processor (905; 805) arranged to receive triggering signals from the temperature sensors; to determine, based on the received triggering signals, any difference in phase and/or frequency between the flow of fluid pulses from the at least two inlet valve devices; and to instruct, in response to a determined difference, an inlet valve device to adjust the phase and/or frequency of the fluid pulse delivery.

9. The arrangement of any one of the above claims, further comprising
a temperature sensor (800) in the fluid flow on the fluid exit side of an element, the temperature sensor being arranged to generate a signal indicative of information relating to the temperature of the fluid; and
a processor (805; 905) arranged to receive a signal indicative of said information;
and to instruct the outlet valve device (115) to adjust a phase and/or frequency of the fluid pulse separation in accordance with the information in order to improve the separation of the heating fluid and the cooling fluid.

10. The arrangement of any one of the above claims, arranged in a manner so that the following relation holds upon operation of the arrangement:

$$N > n = \frac{\Delta T}{\delta T} - 1 \qquad (8),$$

wherein

N is the number of elements in the cascaded series when the arrangement comprises a single cascaded series; or, if the arrangement comprises more than one cascaded series, the number of elements in the longest cascaded series;
$\Delta T$ is an average temperature difference between the cooling fluid and the heating fluid which will be delivered to an element when the arrangement is in operation;
$\delta T$ is the average cooling fluid temperature increase or heating fluid temperature decrease obtained in an element upon operation of the arrangement.

11. The arrangement of any one of the above claims, arranged in a manner so that the following relation holds upon operation of the arrangement:

$$\Delta T \geq 2\delta T \qquad (9),$$

wherein

$\Delta T$ is an average temperature difference between the cooling fluid and the heating fluid which will be delivered to an element when the arrangement is in operation;
$\delta T$ is the average cooling fluid temperature increase or heating fluid temperature decrease obtained in an element upon operation of the arrangement.

12. The arrangement of any one of the above claims, arranged in a manner so that the temperature increase/decrease of an element during operation of the arrangement will be greater for an element having a wider phase transition than for an element having a narrower transition.

13. An electric generator comprising an arrangement of any one of the above claims.

14. A method of operating a thermomagnetic generator having at least two thermomagnetic elements comprising a material exhibiting a magnetic phase transition wherein the elements have different phase transition temperatures, the method comprising:

supplying a first thermomagnetic element of a first phase transition temperature with a unidirectional flow of alternately heating and cooling pulses, the flow of alternately heating and cooling pulses providing temperature cycling of the first element;

separating the unidirectional flow of alternately heating and cooling pulses having provided temperature cycling of the first element into a heating fluid flow and a cooling fluid flow;

supplying a second thermomagnetic element of a second phase transition temperature with the cooling fluid flow, the second phase transition temperature being higher than the first phase transition temperature; and/or

supplying a third thermomagnetic element of a third phase transition temperature with the heating fluid flow, the third phase transition temperature being lower than the first phase transition temperature.

15. The method of claim 14, wherein

the cooling fluid which has been supplied to the thermomagnetic element having the highest transition temperature is provided to a heat source; and

wherein heating fluid used to supply said thermomagnetic element having the highest transition temperature with a flow of alternately heating and cooling fluid pulses is provided from said heat source.

# Fig. 1

$T_H^{in}$

117a

110

120

thermo-
magnetic
element

100

117b

125

$T_C^{out}$

115

$T_C^{in}$

$T_H^{out}$

# Fig. 8a

805  μ

thermo-
magnetic
element

100

800

115

# Fig. 8b

805  μ

800

thermo-
magnetic
element

100

115

# Fig. 2a

# Fig. 2b

# Fig. 2c

Fig. 3

EP 2 267 805 A1

300

Fig. 4

Fig. 5

# Fig. 6

305/405

# Fig. 7

700

# Fig. 9

Europäisches
Patentamt
European
Patent Office
Office européen
des brevets

# EUROPEAN SEARCH REPORT

Application Number

EP 09 16 1615

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | SOLOMON D: "Design of a thermomagnetic generator" ENERGY CONVERSION AND MANAGEMENT, vol. 31, no. 2, 1991, pages 157-173, XP000177184 * section 8; figure 7 * * page 163 - page 164, paragraph 1; figures 5, 6 * | 1,13-14 | INV. H01L37/04 |
| A | DE 196 45 156 A1 (MÄCKEL PETER ET AL) 7 May 1998 (1998-05-07) * column 2, line 25 - column 3, line 54; figures 1,2,4 * | 1,13-14 | |
| A | US 2 510 800 A (CHILOWSKY CONSTANTIN) 6 June 1950 (1950-06-06) * column 4, line 48 - column 5, line 41; figures 1,2 * * column 11, lines 45-55 * | 1,13-14 | |
| A,D | WO 00/36656 A1 (GOVERNMENT OF CANADA; IKURA MICHIO ET AL) 22 June 2000 (2000-06-22) * page 5, line 23 - page 7, line 31; figures 3-5 * | 1,4-5, 13-14 | TECHNICAL FIELDS SEARCHED (IPC) H01L |

The present search report has been drawn up for all claims

| Place of search | Date of completion of the search | Examiner |
|---|---|---|
| Munich | 7 January 2010 | Köpf, Christian |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 09 16 1615

This annex lists the patent family members relating to the patent documents cited in the above-mentioned European search report.
The members are as contained in the European Patent Office EDP file on
The European Patent Office is in no way liable for these particulars which are merely given for the purpose of information.

07-01-2010

| Patent document cited in search report | | Publication date | Patent family member(s) | | Publication date |
|---|---|---|---|---|---|
| DE 19645156 | A1 | 07-05-1998 | NONE | | |
| US 2510800 | A | 06-06-1950 | US | 2648784 A | 11-08-1953 |
| WO 0036656 | A1 | 22-06-2000 | CA | 2355314 A1 | 22-06-2000 |
| | | | DE | 69837624 T2 | 27-12-2007 |
| | | | EP | 1145333 A1 | 17-10-2001 |
| | | | JP | 3955437 B2 | 08-08-2007 |
| | | | JP | 2002532906 T | 02-10-2002 |
| | | | US | 6528898 B1 | 04-03-2003 |

EPO FORM P0459

For more details about this annex : see Official Journal of the European Patent Office, No. 12/82

**EP 2 267 805 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- GB 16709 A, Thomas Edison
- US 428057 A, Nikola Tesla
- US 655087 A
- WO 2008116785 A
- WO 2008116789 A
- WO 2008116792 A
- WO 200036656 A